(19) Europäisches Patentamt
European Patent Office
Office européen des brevets

(11) EP 4 708 332 A1

(12) **EUROPEAN PATENT APPLICATION**
published in accordance with Art. 153(4) EPC

(43) Date of publication:
**11.03.2026 Bulletin 2026/11**

(21) Application number: **25805932.8**

(22) Date of filing: **04.06.2025**

(51) International Patent Classification (IPC):
***H01B 3/30*** *(2006.01)* ***G03F 7/20*** *(2006.01)*
***H01L 21/02*** *(2006.01)*

(52) Cooperative Patent Classification (CPC):
**G03F 7/20; H01B 3/30**

(86) International application number:
**PCT/JP2025/020245**

(87) International publication number:
**WO 2025/258480 (18.12.2025 Gazette 2025/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.06.2024 JP 2024093645**

(71) Applicants:
- **DAIKIN INDUSTRIES, LTD.**
  **Osaka-Shi, Osaka 530-0001 (JP)**
- **University of Hyogo**
  **Kobe-shi, Hyogo 651-2197 (JP)**

(72) Inventors:
- **HOSODA, Kazuki**
  **Osaka-shi, Osaka 530-0001 (JP)**
- **NAMIKAWA, Takashi**
  **Osaka-shi, Osaka 530-0001 (JP)**
- **KISHIKAWA, Yosuke**
  **Osaka-shi, Osaka 530-0001 (JP)**
- **WATANABE, Takeo**
  **Ako-gun, Hyogo 678-1205 (JP)**
- **HARADA, Tetsuo**
  **Ako-gun, Hyogo 678-1205 (JP)**
- **YAMAKAWA, Shinji**
  **Ako-gun, Hyogo 678-1205 (JP)**

(74) Representative: **Hoffmann Eitle**
**Patent- und Rechtsanwälte PartmbB**
**Arabellastraße 30**
**81925 München (DE)**

(54) **ELECTRIC WIRE/CABLE COATING MATERIAL, ELECTRIC WIRE/CABLE, VACUUM DEVICE FOR SEMICONDUCTOR MANUFACTURING APPARATUS, SEMICONDUCTOR MANUFACTURING APPARATUS, AND METHOD FOR MANUFACTURING ELECTRIC WIRE/ CABLE COATING MATERIAL**

(57) The disclosure aims to provide a covering material for an electric wire or a cable for a semiconductor manufacturing apparatus, the covering material reducing emission of an outgassing component even when used in a vacuum. The disclosure also aims to provide an electric wire or a cable containing the covering material, a vacuum device for a semiconductor manufacturing apparatus, a semiconductor manufacturing apparatus, and a method for producing a covering material for an electric wire or a cable. The disclosure provides a covering material for an electric wire or a cable, the covering material being for use in a vacuum device in a semiconductor manufacturing apparatus, the covering material satisfying the following condition A:
(condition A)
a sample has a gas emission rate per unit surface area of $2.0 \times 10^{-9}$ Pa·m$^3$/s/cm$^2$ or lower after being left to stand at 20°C to 30°C and $1.0 \times 10^{-2}$ to $1.0 \times 10^{-4}$ Pa for 48 hours.

EP 4 708 332 A1

## Description

TECHNICAL FIELD

The disclosure relates to covering materials for electric wires or cables, electric wires or cables, vacuum devices for semiconductor manufacturing apparatuses, semiconductor manufacturing apparatuses, and methods for producing covering materials for electric wires or cables.

BACKGROUND ART

With the miniaturization in the semiconductor process, techniques for microfabrication using extreme ultraviolet (EUV) light are being developed. As EUV light attenuates in the atmosphere, exposure with EUV light is performed in a vacuum environment.

Patent Literature 1 discloses that cable surfaces that are exposed to EUV radiation in an EUV lithography system are composed of EUV-resistant materials.

CITATION LIST

- Patent Literature

Patent Literature 1: WO 2010/081721

SUMMARY OF INVENTION

- Technical Problem

The disclosure aims to provide a covering material for an electric wire or a cable for a semiconductor manufacturing apparatus, the covering material reducing emission of an outgassing component even when used in a vacuum. The disclosure also aims to provide an electric wire or a cable containing the covering material, a vacuum device for a semiconductor manufacturing apparatus, a semiconductor manufacturing apparatus, and a method for producing a covering material for an electric wire or a cable.

- Solution to Problem

The disclosure (1) relates to a covering material for an electric wire or a cable, the covering material being for use in a vacuum device in a semiconductor manufacturing apparatus, the covering material satisfying the following condition A:

(condition A)

a sample has a gas emission rate per unit surface area of $2.0 \times 10^{-9}$ Pa·m$^3$/s/cm$^2$ or lower after being left to stand at 20°C to 30°C and $1.0 \times 10^{-2}$ to $1.0 \times 10^{-4}$ Pa for 48 hours.

The disclosure (2) relates to a covering material for an electric wire or a cable, the covering material being for use in a vacuum device in a semiconductor manufacturing apparatus, the covering material satisfying the following condition B:

(condition B)

an outgassing component having a molecular weight of 200 or less has a partial pressure of $1.0 \times 10^{-6}$ Pa or lower upon exposure to EUV light at 20°C to 30°C and $1.0 \times 10^{-4}$ Pa or lower.

The disclosure (3) relates to a covering material for an electric wire or a cable, the covering material being for use in a vacuum device in a semiconductor manufacturing apparatus, the covering material satisfying the following conditions A and B:

(condition A)
a sample has a gas emission rate per unit surface area of $2.0 \times 10^{-9}$ Pa·m$^3$/s/cm$^2$ or lower after being left to stand at 20°C to 30°C and $1.0 \times 10^{-2}$ to $1.0 \times 10^{-4}$ Pa for 48 hours;
(condition B)

an outgassing component having a molecular weight of 200 or less has a partial pressure of $1.0 \times 10^{-6}$ Pa or lower upon exposure to EUV light at 20°C to 30°C and $1.0 \times 10^{-4}$ Pa or lower.

The disclosure (4) relates to a covering material for an electric wire or a cable, the covering material being for use in a vacuum device in a semiconductor manufacturing apparatus, the covering material satisfying the following conditions A, B, and C:

(condition A)
a sample has a gas emission rate per unit surface area of $2.0 \times 10^{-9}$ Pa·m$^3$/s/cm$^2$ or lower after being left to stand at 20°C to 30°C and $1.0 \times 10^{-2}$ to $1.0 \times 10^{-4}$ Pa for 48 hours;
(condition B)
an outgassing component having a molecular weight of 200 or less has a partial pressure of $1.0 \times 10^{-6}$ Pa or lower upon exposure to EUV light at 20°C to 30°C and $1.0 \times 10^{-4}$ Pa or lower;
(condition C)
a CF component has a partial pressure of $2.0 \times 10^{-9}$ Pa or lower upon exposure to EUV light at 20°C to 30°C and $1.0 \times 10^{-4}$ Pa or lower.

The disclosure (5) relates to the covering material for an electric wire or a cable according to any one of the disclosures (1) to (4), wherein the covering material contains a resin.
The disclosure (6) relates to the covering material for an electric wire or a cable according to the disclosure (5), wherein the resin includes at least one selected from the group consisting of a fluororesin, a polyimide resin, and a polyetheretherketone resin.
The disclosure (7) relates to the covering material for an electric wire or a cable according to the disclosure (5), wherein the resin includes a fluororesin.
The disclosure (8) relates to the covering material for an electric wire or a cable according to the disclosure (7), wherein the fluororesin includes an ethylene/tetrafluoroethylene copolymer.
The disclosure (9) relates to the covering material for an electric wire or a cable according to the disclosure (7), wherein the fluororesin includes a perfluororesin.
The disclosure (10) relates to the covering material for an electric wire or a cable according to the disclosure (9), wherein the perfluororesin includes at least one selected from the group consisting of polytetrafluoroethylene, a tetrafluoroethylene/perfluoro(alkyl vinyl ether) copolymer, and a tetrafluoroethylene/hexafluoropropylene copolymer.
The disclosure (11) relates to the covering material for an electric wire or a cable according to the disclosures (9) or (10), wherein the perfluororesin has 40 or less terminal functional groups, per $10^6$ main chain carbon atoms.
The disclosure (12) relates to the covering material for an electric wire or a cable according to any one of the disclosures (7) to (11), wherein the fluororesin has 10 or less terminal functional groups, per $10^6$ main chain carbon atoms.
The disclosure (13) relates to an electric wire or a cable containing:
the covering material for an electric wire or a cable according to any one of the disclosures (1) to (12).
The disclosure (14) relates to the electric wire or the cable according to the disclosure (13), wherein the electric wire or the cable contains the covering material for an electric wire or a cable in an outermost layer thereof.
The disclosure (15) relates to a vacuum device for a semiconductor manufacturing apparatus, containing: the electric wire or the cable according to the disclosure (13) or (14) .
The disclosure (16) relates to a semiconductor manufacturing apparatus containing: the vacuum device for a semiconductor manufacturing apparatus according to the disclosure (15).
The disclosure (17) relates to the semiconductor manufacturing apparatus according to the disclosure (16), wherein the semiconductor manufacturing apparatus includes an EUV light exposure apparatus.
The disclosure (18) relates to a method for producing the covering material for an electric wire or a cable according to any one of the disclosures (1) to (12), the method including: eliminating an outgassing component having molecular weight of 200 or less to satisfy the condition.
The disclosure (19) relates to the production method according to the disclosure (18), wherein the outgassing component is eliminated by thermal degassing.
The disclosure (20) relates to the production method according to the disclosure (19), wherein the thermal degassing is performed at a temperature ranging from 150°C to a temperature that is 20°C or more below a melting point of the covering material for an electric wire or a cable, wherein the thermal degassing is performed for a duration of five minutes to three hours.

- Advantageous Effects of Invention

The disclosure can provide a covering material for an electric wire or a cable for a semiconductor manufacturing

apparatus, the covering material reducing emission of an outgassing component even when used in a vacuum. The disclosure can also provide an electric wire or a cable containing the covering material, a vacuum device for a semiconductor manufacturing apparatus, a semiconductor manufacturing apparatus, and a method for producing a covering material for an electric wire or a cable.

DESCRIPTION OF EMBODIMENTS

The disclosure will be specifically described below.

The disclosure relates to a covering material (hereinafter also referred to as a covering material (1) of the disclosure) for an electric wire or a cable, the covering material being for use in a vacuum device in a semiconductor manufacturing apparatus, the covering material satisfying the following condition A:

(condition A)

a sample has a gas emission rate per unit surface area of $2.0 \times 10^{-9}$ Pa·m$^3$/s/cm$^2$ or lower after being left to stand at 20°C to 30°C and $1.0 \times 10^{-2}$ to $1.0 \times 10^{-4}$ Pa for 48 hours.

The disclosure also relates to a covering material (hereinafter also referred to as a covering material (2) of the disclosure) for an electric wire or a cable, the covering material being for use in a vacuum device in a semiconductor manufacturing apparatus, the covering material satisfying the following condition B:

(condition B)

an outgassing component having a molecular weight of 200 or less has a partial pressure of $1.0 \times 10^{-6}$ Pa or lower upon exposure to EUV light at 20°C to 30°C and $1.0 \times 10^{-4}$ Pa or lower.

The disclosure also relates to a covering material (hereinafter also referred to as a covering material (3) of the disclosure) for an electric wire or a cable, the covering material being for use in a vacuum device in a semiconductor manufacturing apparatus, the covering material satisfying the above-mentioned conditions A and B.

The disclosure also relates to a covering material (hereinafter also referred to as a covering material (4) of the disclosure) for an electric wire or a cable, the covering material being for use in a vacuum device in a semiconductor manufacturing apparatus, the covering material satisfying the following conditions A, B, and C:

(conditions A and B)
as described above;
(condition C)
a CF component has a partial pressure of $2.0 \times 10^{-9}$ Pa or lower upon exposure to EUV light at 20°C to 30°C and $1.0 \times 10^{-4}$ Pa or lower.

Herein, the covering materials (1) to (4) of the disclosure are collectively referred to as "the covering material of the disclosure", unless otherwise stated.

By satisfying the specified condition(s), the covering material of the disclosure reduces emission of an outgassing component even when used in a vacuum, resulting in reduced contamination of a vacuum device in a semiconductor manufacturing apparatus.

The condition A specifies the gas emission rate of $2.0 \times 10^{-9}$ Pa ·m$^3$/s/cm$^2$ or lower. In order to further suppress emission of outgassing components in a vacuum and further reduce contamination of a vacuum device, the gas emission rate is preferably $1.0 \times 10^{-9}$ Pa ·m$^3$/s/cm$^2$ or lower, more preferably $8.0 \times 10^{-10}$ Pa ·m$^3$/s/cm$^2$ or lower, still more preferably $5.0 \times 10^{-10}$ Pa ·m$^3$/s/cm$^2$ or lower, further preferably $3.0 \times 10^{-10}$ Pa ·m$^3$/s/cm$^2$ or lower.

The lower limit thereof is not limited, but it may be $1.0 \times 10^{-11}$ Pa ·m$^3$/s/cm$^2$ or may also be $1.0 \times 10^{-10}$ Pa ·m$^3$/s/cm$^2$.

The gas emission rate is measured by the following throughput method test.

A sample is put in a test chamber, followed by switching to orifice exhaust when the pressure reaches a specific value. After the pressure (P1) of a sample chamber falls below $1.0 \times 10^{-2}$ Pa, the measurement by Q-Mass (QMS) is initiated. The test continues for 48 hours from the initiation of the QMS measurement under the conditions described above. During the test, the temperature of the sample chamber is held at 20°C to 30°C and a pressure of $1.0 \times 10^{-2}$ to $1.0 \times 10^{-4}$ Pa. The pressure is measured for the period from the initiation to the end of vacuum exhaust to calculate the gas emission rate Q by the following formula:

$$Q = C(P1-P2)$$

wherein C is an orifice conductance ($m^3/s$), P1 is an orifice upstream (sample chamber side) pressure (Pa), and P2 is an orifice downstream (exhaust chamber side) pressure (Pa).

The calculated gas emission rate is standardized with a surface area of the sample to determine the gas emission rate per unit surface area of the sample.

The sample may be either a covering material to be measured alone or, an electric wire or a cable containing the covering material (This also applies to conditions B and C).

The condition B specifies the partial pressure of an outgassing component of $1.0 \times 10^{-6}$ Pa or lower. In order to further suppress emission of outgassing components in a vacuum and further reduce contamination of a vacuum device, the partial pressure is preferably $8.0 \times 10^{-7}$ Pa or lower, more preferably $5.0 \times 10^{-7}$ Pa or lower, still more preferably $4.0 \times 10^{-7}$ Pa or lower, further preferably $3.0 \times 10^{-7}$ Pa or lower, particularly preferably $2.0 \times 10^{-7}$ Pa or lower.

The lower limit thereof is not limited, but it may be $1.0 \times 10^{-8}$ Pa or may also be $1.0 \times 10^{-7}$ Pa, for example.

The partial pressure of an outgassing component is measured with the following method.

After the degree of vacuum in an exposure chamber falls below $1.0 \times 10^{-4}$ Pa, EUV light with a wavelength of 13.5 nm and beam size 2.6 mm $\times$ 4.1 mm is directed to the surface of a sample placed in an exposure chamber. During the EUV irradiation, the chamber is held at a temperature of 20°C to 30°C and a pressure of $1.0 \times 10^{-4}$ Pa or lower. The result of QMS measurement without EUV irradiation serves as baseline value. The value obtained by subtracting the baseline value from the result of the QMS measurement during the EUV irradiation is defined as an actual amount of outgassing amount during the EUV irradiation. Furthermore, the partial pressure of outgassing components having a molecular weight of 200 or less upon exposure to EUV light is determined by subtracting partial pressures of atmosphere components such as water (molecular weight: 18), nitrogen (molecular weight: 28), oxygen (molecular weight: 32), argon (molecular weight: 40), and carbon dioxide (molecular weight: 44) from the sum of partial pressures of outgassing components having molecular weight of 200 or less.

The condition C specifies the partial pressure of a CF component of $2.0 \times 10^{-9}$ Pa or lower. In order to further suppress emission of outgassing components in a vacuum and further reduce contamination of a vacuum device, the partial pressure is preferably $1.5 \times 10^{-9}$ Pa or lower, more preferably $1.0 \times 10^{-9}$ Pa or lower, still more preferably $5.0 \times 10^{-10}$ Pa or lower.

The lower limit thereof is not limited, but it may be $1.0 \times 10^{-11}$ Pa or may also be $1.0 \times 10^{-10}$ Pa, for example.

The partial pressure of a CF component is measured with the following method.

After the degree of vacuum in an exposure chamber falls below $1.0 \times 10^{-4}$ Pa, EUV light with a wavelength of 13.5 nm and beam size 2.6 mm $\times$ 4.1 mm is directed to the surface of a sample placed in an exposure chamber. During the EUV irradiation, the chamber is held at a temperature of 20°C to 30°C and a pressure of $1.0 \times 10^{-4}$ Pa or lower. The result of QMS measurement without EUV irradiation serves as baseline value. The value obtained by subtracting the baseline value from the result of the QMS measurement during the EUV irradiation is defined as an actual amount of outgassing amount during the EUV irradiation. Furthermore, the sum of partial pressures of components ($C_2F_4$) having a molecular weight of 100; ($C_2F_5$) having a molecular weight of 119; and ($C_3F_7$) having a molecular weight of 169 is determined as the partial pressure of CF components upon exposure to EUV light.

The covering material of the disclosure may contain either an inorganic material or an organic material. In order to impart flexibility to an electric wire or a cable, the covering material preferably contains an organic material.

Both an inorganic material and an organic material may be used in combination.

Examples of the inorganic material include metals such as aluminum, platinum, and molybdenum; ceramics such as boron nitride, aluminum nitride, magnesium oxide, aluminum oxide, silicon dioxide, silicon carbide, and glass ceramic, with ceramics being preferred.

Examples of the ceramics include an oxide-based ceramic, a non-oxide-based ceramic, and a ceramic that is primarily composed of ceramic composites thereof.

Examples of the oxide-based ceramic include alumina (aluminum oxide, $Al_2O_3$), zirconia (zirconium oxide, $ZrO_2$), yttria (yttrium oxide, $Y_2O_3$), talc (hydrous magnesium silicate, $Mg_3Si_4O_{10}(OH)_{10}$), hematite (iron(III) oxide, $Fe_2O_3$), chromia (chromium(III) oxide, $Cr_2O_3$), titania (titanium(IV) oxide, $Ti_2O$), magnesia (magnesium oxide, MgO), silica (silicon dioxide, $SiO_2$), calcia (calcium oxide, CaO), ceria (cerium(IV) oxide, $CeO_2$), tin oxide ($SnO_2$), zinc oxide (ZnO), steatite (magnesium metasilicate, $MgO \cdot SiO_2$), cordierite ($2MgO\text{-}2Al,O_3\ 5SiO_2$), mullite ($3Al_2O_3 \cdot 2SiO_2$), ferrite ($MnFe_2O_4$), spinel ($MgAl_2O_4$), zircon ($ZrSiO_4$), barium titanate ($BaTiO_3$), lead titanate ($PbTiO_3$), forsterite ($Mg_2SiO_4$), phosphorus-doped tin oxide (PTO), antimony-doped tin oxide (ATO), and tin-doped indium oxide (ITO). These oxide-based ceramics may be used alone or in combination of two or more thereof.

Examples of the non-oxide-based ceramic include a nitride ceramic, a carbide-based ceramic, a boride-based ceramic, a silicide-based ceramic, and a phosphate compound.

Examples of the nitride ceramic include boron nitride (BN), titanium nitride (TiN), silicon nitride ($Si_3N_4$), gallium nitride (GaN), aluminum nitride (AlN), carbon nitride ($CN_x$), and sialon ($Si_3N_4\text{-}AlN\text{-}Al_2O_3$ solid solution) .

Examples of the carbide-based ceramic include tungsten carbide (WC), chromium carbide (CrC), vanadium carbide (VC), niobium carbide (NbC), molybdenum carbide (MoC), tantalum carbide (TaC), titanium carbide (TiC),

zirconium carbide (ZrC), hafnium carbide (HfC), silicon carbide (SiC), and boron carbide ($B_4C$).

Examples of the boride-based ceramic include molybdenum boride (MoB), chromium boride ($CrB_2$), hafnium boride ($HfB_2$), zirconium boride ($ZrB_2$), tantalum boride ($TaB_2$), and titanium boride ($TiB_2$).

Examples of the silicide-based ceramic include zirconium oxide silicate, hafnium oxide silicate, titanium oxide silicate, lanthanum oxide silicate, yttrium oxide silicate, titanium oxide silicate, tantalum oxide silicate, and tantalum oxynitride silicate.

Examples of the phosphate compound include hydroxyapatite and calcium phosphate.

These non-oxide-based ceramics may be used alone or in combination of two or more thereof.

The ceramic preferably includes at least one selected from the group consisting of alumina, magnesia, yttria, zirconia, silica, and zinc oxide.

The ceramic may contain any of the above ceramic materials as primary component. The ceramic may also contain a different component without impairing the effects of the disclosure. For example, the ceramic may contain the ceramic material(s) in an amount of 80% by mass or more and may also contain a ceramic that contains a metal such as Fe, Cr, or C as a different component.

Examples of the organic material include a resin and a rubber. Preferred is a resin.

In order to further suppress emission of outgassing components in a vacuum, further reduce contamination of a vacuum device, and enhance heat resistance, the resin preferably has a continuous use temperature of 150°C or more. Examples of such a resin include fluororesin, polyimide resin, aromatic polyetherketone resin, polyamide-imide resin, polyethersulfone resin, polyetherimide resin, aromatic polyester resin, and polyarylene sulfide resin.

Among these, preferred is at least one selected from the group consisting of fluororesin, polyimide resin, and aromatic polyetherketone resin, with at least one selected from the group consisting of fluororesin and polyimide resin being more preferred, and with a fluororesin being still more preferred.

Examples of the fluororesin include polytetrafluoroethylene (PTFE), a tetrafluoroethylene (TFE)/perfluoro(alkyl vinyl ether) (PAVE) copolymer (PFA), a TFE/hexafluoropropylene (HFP) copolymer (FEP), an ethylene (Et)/TFE copolymer (ETFE), an Et/TFE/HFP copolymer (EFEP), polychlorotrifluoroethylene (PCTFE), a chlorotrifluoroethylene (CTFE)/TFE copolymer, a CTFE/TFE/PAVE copolymer, an Et/CTFE copolymer, polyvinyl fluoride (PVF), polyvinylidene fluoride (PVdF), a vinylidene fluoride (VdF)/TFE copolymer, a VdF/HFP copolymer, a VdF/TFE/HFP copolymer, a VdF/HFP/(meth)acrylic acid copolymer, a VdF/CTFE copolymer, a VdF/pentafluoropropylene copolymer, a VdF/PAVE/TFE copolymer, and a TFE/perfluoroalkyl allyl ether copolymer. The perfluoroalkyl allyl ether is a monomer represented by $CF_2=CFCF_2-O-Rf^4$ (wherein $Rf^4$ is a C1-C5 perfluoroalkyl group).

In order to further suppress emission of outgassing components in a vacuum, further reduce contamination of a vacuum device, and enhance heat resistance, the fluororesin preferably includes a perfluororesin.

Herein, perfluororesin is a resin composed of a perfuloropolymer in which all the monovalent atoms bonded to the carbon atoms constituting the polymer main chain are fluorine atoms.

Yet, in addition to monovalent atoms (fluorine atoms), groups such as a fluoroalkyl group and a fluoroalkoxy group may be bonded to the carbon atoms constituting the polymer main chain. At a polymer end group, i.e. a group that terminates a polymer chain, an atom other than a fluorine atom may be present. The polymer end group is generally a group derived from a polymerization initiator or a chain transfer agent used for polymerization reaction or from a chemical structure after thermal decomposition thereof.

The perfluororesin preferably includes at least one selected from the group consisting of PTFE, PFA, and FEP.

The fluororesin may be a fluororesin having a hydrogen atom bonded to a carbon atom constituting the polymer main chain and is preferably ETFE, for example.

In order to further suppress emission of outgassing components in a vacuum and further reduce contamination of a vacuum device, the fluororesin preferably includes at least one selected from the group consisting of PTFE, PFA, FEP, and ETFE, more preferably at least one selected from the group consisting of PTFE and ETFE, still more preferably PTFE.

The PTFE may be a TFE homopolymer consisting of a tetrafluoroethylene (TFE) unit, or may be a modified PTFE containing a TFE unit and a modifying monomer unit based on a modifying monomer that is copolymerizable with TFE.

The modifying monomer may be any monomer copolymerizable with TFE, and examples thereof include: perfluoroolefins such as hexafluoropropylene (HFP); chlorofluoroolefins such as chlorotrifluoroethylene (CTFE); hydrogen-containing fluoroolefins such as trifluoroethylene and vinylidene fluoride (VdF); perfluorovinyl ethers; perfluoroalkyl allyl ethers; (perfluoroalkyl)ethylenes; and ethylene. One modifying monomer may be used or a plurality of modifying monomers may be used.

Examples of the perfluorovinyl ether include, but are not limited to, unsaturated perfluoro compounds represented by the following formula (1):

$$CF_2=CF-ORf \quad (1)$$

wherein Rf is a perfluoroorganic group. The term "perfluoroorganic group" herein means an organic group in which all

hydrogen atoms bonded to any carbon atom are replaced by fluorine atoms. The perfluoroorganic group may have an ether oxygen.

Examples of the perfluorovinyl ether include a perfluoro(alkyl vinyl ether) (PAVE) represented by the formula (1) in which Rf is a C1-C10 perfluoroalkyl group. The perfluoroalkyl group preferably has a carbon number of 1 to 5.

Examples of the perfluoroalkyl group in the PAVE include a perfluoromethyl group, a perfluoroethyl group, a perfluoropropyl group, a perfluorobutyl group, a perfluoropentyl group, and a perfluorohexyl group. Preferred is perfluoro(propyl vinyl ether) (PPVE) in which the perfluoroalkyl group is a perfluoropropyl group.

Examples of the perfluorovinyl ether also include: those represented by the formula (1) wherein Rf is a C4-C9 perfluoro(alkoxy alkyl) group; those represented by the formula (1) wherein Rf is a group represented by the following formula:

[Chem. 1]

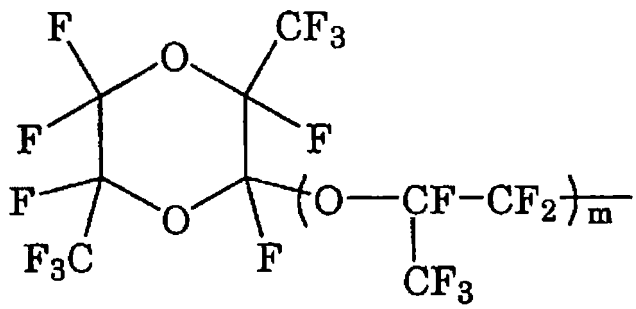

wherein m is 0 or an integer of 1 to 4; and those represented by the formula (1) wherein Rf is a group represented by the following formula:

[Chem. 2]

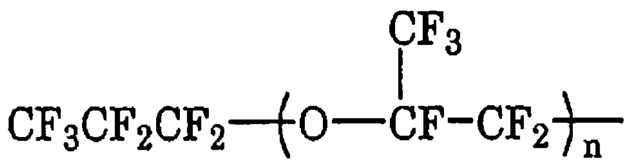

wherein n is an integer of 1 to 4.

Examples of the (perfluoroalkyl)ethylene include, but are not limited to, (perfluorobutyl)ethylene (PFBE), (perfluorohexyl)ethylene (PFHE), and (perfluorooctyl)ethylene.

The modifying monomer in the modified PTFE preferably includes at least one selected from the group consisting of HFP, CTFE, VdF, PPVE, PFBE, and ethylene, with at least one selected from the group consisting of HFP and CTFE being more preferred.

The modified PTFE preferably contains a modifying monomer unit in an amount falling within a range of 0.00001 to 1.0% by mass. The lower limit of the amount of the modifying monomer unit is more preferably 0.0001% by mass, still more preferably 0.001% by mass, further preferably 0.005% by mass, even more preferably 0.010% by mass, particularly preferably 0.030% by mass. The upper limit of the amount of the modifying monomer unit is preferably 0.90% by mass, more preferably 0.50% by mass, still more preferably 0.40% by mass, further preferably 0.30% by mass.

The modifying monomer unit herein means a moiety that is part of the molecular structure of modified PTFE and is derived from a modifying monomer. All the monomer units herein mean all the moieties derived from monomers in the molecular structure of the modified PTFE.

The PTFE preferably has a melting point of 324°C to 360°C. The melting point of PTFE means the first melting point. The first melting point is the temperature corresponding to the maximum value on a heat-of-fusion curve obtained by heating a PTFE that has no history of being heated up to a temperature of 300°C or higher, at a rate of 10°C/min using a differential scanning calorimeter (DSC).

The PTFE preferably has a standard specific gravity (SSG) of 2.130 to 2.280. The specific gravity is more preferably 2.220 or lower, still more preferably 2.200 or lower, while preferably 2.140 or higher, more preferably 2.150 or higher. The SSG is measured by a water displacement method in conformity with ASTM D-792 using a sample molded in conformity with ASTM D 4895-89.

The PTFE preferably has non-melt secondary processibility. The non-melt secondary processibility means a

property of a polymer such that the melt flow rate cannot be measured at a temperature higher than the crystallization melting point in conformity with ASTM D-1238 and D-2116.

The PFA is preferably, but is not limited to, a copolymer in which the mole ratio of the TFE unit to the PAVE unit ((TFE unit)/(PAVE unit)) is 70/30 or higher and lower than 99/1. The mole ratio is more preferably 70/30 or higher and 98.9/1.1 or lower, still more preferably 80/20 or higher and 98.9/1.1 or lower. The PFA is preferably a copolymer containing a monomer unit derived from a monomer copolymerizable with TFE and PAVE in an amount of 0.1 to 10 mol% (the sum of the TFE unit and the PAVE unit is 90 to 99.9 mol%), more preferably 0.1 to 5 mol%, particularly preferably 0.2 to 4 mol%.

Examples of the monomer copolymerizable with TFE and PAVE include HFP, a vinyl monomer represented by the formula (I): $CZ^1Z^2=CZ^3(CF_2)_nZ^4$ (wherein $Z^1$, $Z^2$, and $Z^3$ are the same as or different from each other and each are a hydrogen atom or a fluorine atom; $Z^4$ is a hydrogen atom, a fluorine atom, or a chlorine atom; and n is an integer of 2 to 10), an alkyl perfluorovinyl ether derivative represented by the formula (II): $CF_2=CF-OCH_2-Rf^1$ (wherein $Rf^1$ is a C1-C5 perfluoroalkyl group), and an allyl ether monomer represented by the formula (X): $CZ^5Z^6=CZ^7-CZ^8Z^9-O-Rf^4$ (wherein $Z^5$, $Z^6$, and $Z^7$ are the same as or different from each other and each represent a hydrogen atom, a chlorine atom, or a fluorine atom; $Z^8$ and $Z^9$ each are a hydrogen atom or a fluorine atom; and $Rf^4$ is a C1-C5 perfluoroalkyl group). Preferred examples of the allyl ether monomer include $CH_2=CFCF_2-O-Rf^4$ $CF_2=CFCF_2-O-Rf^4$ (perfluoroalkyl allyl ether), $CF_2=CFCH_2-O-Rf^4$, and $CH_2=CHCF_2-O-Rf^4$ (wherein $Rf^4$ is the same as that in the formula (X)).

Examples of the monomer copolymerizable with TFE and PAVE further include unsaturated monocarboxylic acids, unsaturated dicarboxylic acids, and acid anhydrides of unsaturated dicarboxylic acids, such as itaconic acid, itaconic anhydride, citraconic anhydride, and 5-norbornene-2,3-dicarboxylic anhydride.

The PFA preferably has a melting point of 180°C or higher and lower than 324°C, more preferably 230°C to 320°C, still more preferably 280°C to 320°C.

The melting point is the temperature corresponding to the maximum value on a heat-of-fusion curve obtained by heating a PFA at a rate of 10°C/min using a differential scanning calorimeter (DSC).

The FEP is preferably, but is not limited to, a copolymer in which the mole ratio of the TFE unit to the HFP unit ((TFE unit)/(HFP unit)) is 70/30 or higher and lower than 99/1. The mole ratio is more preferably 70/30 or higher and 98.9/1.1 or lower, still more preferably 80/20 or higher and 98.9/1.1 or lower. The FEP is preferably a copolymer containing a monomer unit derived from a monomer copolymerizable with TFE and HFP in an amount of 0.1 to 10 mol% (the sum of the TFE unit and the HFP unit is 90 to 99.9 mol%), more preferably 0.1 to 5 mol%, particularly preferably 0.2 to 4 mol%.

Examples of the monomer copolymerizable with TFE and HFP include PAVE, a monomer represented by the formula (X), and an alkyl perfluorovinyl ether derivative represented by the formula (II).

Examples of the monomer copolymerizable with TFE and HFP also include unsaturated monocarboxylic acids, unsaturated dicarboxylic acids, and acid anhydrides of unsaturated dicarboxylic acids, such as itaconic acid, itaconic anhydride, citraconic anhydride, and 5-norbornene-2,3-dicarboxylic anhydride.

The FEP preferably has a melting point of 150°C or higher and lower than 324°C, more preferably 200°C to 320°C, still more preferably 240°C to 320°C.

The ETFE is preferably, but is not limited to, a copolymer in which the mole ratio of the TFE unit to the ethylene unit ((TFE unit)/(ethylene unit)) is 20/80 or higher and 90/10 or lower. The mole ratio is more preferably 37/63 or higher and 85/15 or lower, still more preferably 38/62 or higher and 80/20 or lower. The ETFE may be a copolymer containing TFE, ethylene, and a monomer copolymerizable with TFE and ethylene. Examples of the copolymerizable monomer include monomers represented by any of the formulas: $CH_2=CX^1Rf^2$, $CF_2=CFRf^2$, $CF_2=CFORf^2$, and $CH_2=C(Rf^2)_2$ (wherein $X^1$ is a hydrogen atom or a fluorine atom; and $Rf^2$ is a fluoroalkyl group optionally containing an ether bond) and monomers represented by the formula (X). Preferred among these are fluorine-containing vinyl monomers represented by any of $CF_2=CFRf^2$, $CF_2=CFORf^2$, and $CH_2=CX^1Rf^2$ and monomers represented by the formula (X). More preferred are HFP, a perfluoro(alkyl vinyl ether) represented by $CF_2=CF-ORf^3$ (wherein $Rf^3$ is a C1-C5 perfluoroalkyl group), a perfluoro (alkyl allyl ether) represented by $CF_2=CF-CF_2-O-Rf^4$ (wherein $Rf^4$ is a C1-C5 perfluoroalkyl group), and a fluorine-containing vinyl monomer represented by $CH_2=CX^1Rf^2$ wherein $Rf^2$ is a C1-C8 fluoroalkyl group. Examples of the monomer copolymerizable with TFE and ethylene may include aliphatic unsaturated carboxylic acids such as itaconic acid and itaconic anhydride. The monomer copolymerizable with TFE and ethylene is preferably contained in an amount of 0.1 to 10 mol%, more preferably 0.1 to 5 mol%, particularly preferably 0.2 to 4 mol% relative to the fluorine-containing polymer.

The ETFE preferably has a melting point of 140°C or higher and lower than 324°C, more preferably 160°C to 320°C, still more preferably 195°C to 320°C.

The ETFE may have a crosslinking structure. The crosslinking structure may be formed by either electron beam irradiation or EUV light exposure.

The amount of each monomer unit in the polymer can be calculated appropriately using any combination of NMR, FT-IR, elemental analysis, and X-ray fluorescence analysis depending on the monomer type.

In order to further suppress emission of outgassing components in a vacuum and further reduce contamination of a vacuum device, the fluororesin (preferably perfluororesin) may have 60 or less, preferably 40 or less, more preferably 30 or less, still more preferably 20 or less, further preferably 15 or less, particularly preferably 10 or less terminal functional

groups, and may also have 0 or more, 1 or more, or 2 or more terminal functional groups per $10^6$ main chain carbon atoms.

The terminal functional group may include at least one selected from the group consisting of -COF group, -COOH group, -$COOCH_3$ group, -CF=$CF_2$ group, -OH group, and ROCOO- group. R in ROCOO- group preferably includes a linear or branched alkyl group and the alkyl group may have 1 to 15 carbon atoms.

The number of terminal functional groups is determined as follows. A 200-μm-thick film is subjected to the infrared spectrum analysis. In the resulting infrared absorption spectrum, the absorbance of the peak present at 2900 to 3100 $cm^{-1}$ assigned to the $CH_2$ groups in the main chain is standardized to 1.0. The absorbance A of the peak assigned to the terminal functional groups in this spectrum is then determined and the number of the terminal functional groups is calculated by the following formula. Coefficient K is as shown in Table 1.

Number of terminal functional groups per $10^6$ main chain carbon atoms = K $\times$ A

[Table 1]

| Unstable end group | Position of absorption wavelength of peak ($cm^{-1}$) | Coefficient K |
|---|---|---|
| COF group | 1850 - 1910 | 3584 |
| COOH group | 1750 - 1850 | 4057 |
| $COOCH_3$ group | 1770 - 1810 | 3162 |
| $CFCF_2$ group | 1770 - 1810 | 3386 |
| OH group | 3610 - 3660 | 20677 |
| ROCOO group | 1780 - 1830 | 1265 |

The number of terminal functional groups can be reduced by fluorination treatment on the fluorinated fluororesin, for example.

The fluorination treatment can be performed by a known method, such as contact between a fluororesin without fluorination treatment and a fluorine-containing compound.

Examples of the fluorine-containing compound include fluorine radical sources that generate fluorine radicals under fluorination treatment conditions, such as $F_2$ gas, $CoF_3$, $AgF_2$, $UF_6$, $OF_2$, $N_2F_2$, $CF_3OF$, and halogen fluorides, e.g., $IF_5$ and $ClF_3$.

The polyimide resin is a polymer compound having an imide bond in a molecular chain and is narrowly defined as an aromatic polyimide resin. The polyimide resin may be obtained by a two-step process involving dehydration and cyclization (imidization) of polyamic acid that is produced by condensation of tetracarboxylic acid or dianhydride thereof and diamine. The polyimide resin may also be obtained by a single-step process of making tetracarboxylic acid or dianhydride thereof react with diisocyanate.

Examples of the tetracarboxylic acid and dianhydride thereof as raw materials of the polyimide resin include pyromellitic dianhydride, 1,1-bis(2,3-dicarboxyphenyl)ethane dianhydride, 3,3',4,4'-biphenyltetracarboxylic dianhydride, bis(2,3-dicarboxyphenyl)methane dianhydride, bis(3,4-dicarboxyphenyl)methane dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl)-1,1,1,3,3,3-hexafluoropropane dianhydride, 2,2-bis(2,3-dicarboxyphenyl)-1,1,1,3,3,3-hexafluoropropane dianhydride, 3,3',4,4'-benzophenonetetracarboxylic dianhydride, bis(3,4-dicarboxyphenyl)ether dianhydride, bis(2,3-dicarboxyphenyl)ether dianhydride, oxydiphthalic anhydride, benzophenonetetracarboxylic dianhydride, 1,2,5,6-naphthalenetetracarboxylic dianhydride, 1,4,5,8-naphthalenetetracarboxylic dianhydride, 2,3,6,7-naphthalenetetracarboxylic dianhydride, 1,2,3,4-benzenetetracarboxylic dianhydride, diphthalic dianhydride, 3,4,9,10-perylenetetracarboxylic dianhydride, 2,3,6,7-anthracenetetracarboxylic dianhydride, 1,2,7,8-phenanthrenetetracarboxylic dianhydride, 9,9-bis(3,4-dicarboxyphenyl)fluorene dianhydride, and 3,3',4,4'-diphenylsulfonetetracarboxylic dianhydride.

Examples of aliphatic tetracarboxylic dianhydride include ethylenetetracarboxylic dianhydride, butanetetracarboxylic dianhydride, cyclopentanetetracarboxylic dianhydride, cyclohexanetetracarboxylic dianhydride, 1,2,4,5-cyclohexanetetracarboxylic dianhydride, and 1,2,3,4-cyclohexanetetracarboxylic dianhydride.

These tetracarboxylic dianhydrides may be used alone or in combination of two or more thereof.

Examples of the diamine include 4,4'-diaminodiphenyl ether (ODA), 4,4'-diaminobenzophenone, 4,4'-diaminodiphenylmethane, 2,2-bis(4-aminophenyl)hexafluoropropane, 4,4'-oxydianiline, 3,3'-oxydianiline, 1,4-phenylenediamine (p-phenylenediamine; PDA), 4,4'-diamino-2,2'-dimethylbiphenyl, 3,4-phenylenediamine, 4,4'-isopropylidenebis-((4-aminophenoxy)benzene), 2,4,6-trimethyl-1,3-phenylenediamine, 4,4'-methylenebis(2-chloroaniline), o-toluidine, 3,4'-diaminodiphenyl ether, 3,4'-diaminodiphenylmethane, and 3,6-diaminocarbazole.

Examples of the diisocyanate include m-xylene diisocyanate, methylene diphenyl 4,4'-diisocyanate, toluene-2,4-diisocyanate, tolylene diisocyanate, 1,4-phenylene diisocyanate, and tolylene-2,6-diisocyanate.

The aromatic polyetherketone resin may be any one containing a repeating unit containing an arylene group, an ether group (-O-), and a carbonyl group (-C(=O)-), and may contain, for example, any of the repeating units represented by the following formulas (a1) to (a5):

[-Ar-O-Ar-C(=O)-] (a1);

[-Ar-O-Ar-C(=O)-Ar-C(=O)-] (a2);

[-Ar-O-Ar-O-Ar-C(=O)-] (a3);

[-Ar-O-Ar-C(=O)-Ar-O-Ar-C(=O)-Ar-C(=O)-] (a4);

and

[-Ar-O-Ar-O-Ar-C(=O)-Ar-C(=O)-] (a5),

wherein Ar is a divalent aromatic hydrocarbon ring group optionally containing a substituent.

Examples of the divalent aromatic hydrocarbon ring group represented by Ar include: C6-C10 arylene groups such as phenylene groups, including an o-, m-, or p-phenylene group, and a naphthylene group; biarylene groups such as biphenylene groups, including a 2,2'-biphenylene group, a 3,3'-biphenylene group, and a 4,4'-biphenylene group, where each arylene group has a carbon number of 6 to 10; and terarylene groups such as an o-, m-, or p-terphenylene group, where each arylene group has a carbon number of 6 to 10. These aromatic hydrocarbon ring groups may have any substituent such as a halogen atom, an alkyl group, e.g., a linear or branched C1-C4 alkyl group such as a methyl group, a haloalkyl group, a hydroxy group, an alkoxy group, e.g., a linear or branched C1-C4 alkoxy group such as a methoxy group, a mercapto group, an alkylthio group, a carboxy group, a sulfo group, an amino group, a N-substituted amino group, or a cyano group. In the repeating units (a1) to (a5), Ar groups may be the same as or different from each other.

Ar is preferably a phenylene group such as a p-phenylene group or a biphenylene group such as a 4,4'-biphenylene group.

An example of a resin containing the repeating unit (a1) is polyetherketone such as "PEEK-HT" available from Victrex.

An example of a resin containing the repeating unit (a2) is polyetherketoneketone such as "PEKK" available from Arkema + Oxford Performance Materials.

Examples of a resin containing the repeating unit (a3) include polyetheretherketone such as "VICTREX PEEK" available from Victrex, "Vestakeep®" available from Evonik, "Vestakeep-J" available from Daicel-Evonik, and "KetaSpire®" available from Solvay Specialty Polymers, and polyether-diphenyl-ether-phenyl-ketone-phenyl such as "Kadel®" available from Solvay Specialty Polymers.

An example of a resin containing the repeating unit (a4) is polyetherketoneetherketoneketone such as "VICTREX ST" available from Victrex. An example of a resin containing the repeating unit (a5) is polyetheretherketoneketone.

In the repeating unit containing an arylene group, an ether group, and a carbonyl group, the ratio (E/K) of an ether segment (E) to a ketone segment (K) may be, for example, 0.5 to 3, preferably about 0.5 to 2.0. The ether segment imparts flexibility to the molecule chain and the ketone segment imparts stiffness to the molecule chain. Thus, the larger the amount of the ether segment is, the higher the crystallization speed tends to be and the higher the crystallinity finally achieved tends to be, while the larger the amount of the ketone segment is, the higher the glass transition temperature tends to be and the higher the melting point tends to be.

One of these aromatic polyetherketone resins may be used alone or two or more thereof may be used in combination.

Preferred among these aromatic polyetherketone resins are aromatic polyetherketone resins containing any of the repeating units (a1) to (a4). For example, the aromatic polyetherketone resin preferably includes at least one resin selected from the group consisting of polyetherketone, polyetheretherketone, polyetherketoneketone, and polyetherketoneetherketoneketone, more preferably at least one resin selected from the group consisting of polyetherketone, polyetheretherketone, and polyetherketoneketone. In order to produce a molded article exhibiting much better tensile elongation at break, much better impact strength, much better toughness, much better sliding properties, and much lower dielectricity, polyetherketoneketone is particularly preferred.

The aromatic polyetherketone resin preferably has a melt flow rate (MFR), which is measured at 380°C and a 5000-g load, of 1 to 150 g/10 min, more preferably 5 to 130 g/10 min, still more preferably 10 to 100 g/10 min. A MFR within

this range allows the resulting molded article to have much better impact strength and tensile elongation.

The MFR of the aromatic polyetherketone resin is measured using a melt indexer in conformity with ASTM D1238.

The aromatic polyetherketone resin preferably has a melt viscosity of 0.01 to 4.0 $kNsm^{-2}$ at 60 $sec^{-1}$ and 390°C. A melt viscosity within this range can lead to improved processibility. The lower limit of the melt viscosity is preferably 0.05 $kNsm^{-2}$, more preferably 0.10 $kNsm^{-2}$, still more preferably 0.15 $kNsm^{-2}$. The upper limit of the melt viscosity is preferably 2.5 $kNsm^{-2}$, more preferably 1.5 $kNsm^{-2}$, still more preferably 1.0 $kNsm^{-2}$.

The melt viscosity of the aromatic polyetherketone resin is measured in conformity with ASTM D3835-02.

The covering material of the disclosure may further contain any component other than those materials described above, without impairing the effects.

The covering material of the disclosure may further contain a pigment. Examples of the pigment include an organic or inorganic insulating pigment. In order to further suppress emission of outgassing components in a vacuum and further reduce contamination of a vacuum device, an inorganic insulating pigment is preferred.

The pigment is preferably contained in an amount of 0.01% by mass or more, more preferably 0.03% by mass or more, and also preferably 5% by mass or less, more preferably 3% by mass or less relative to the covering material.

The covering material of the disclosure is produced, for example, by processing the aforementioned materials using a known method.

The covering material of the disclosure is also suitably produced by a production method including eliminating an outgassing component having molecular weight of 200 or less to satisfy the specified condition(s) that each of the covering materials (1) to (4) of the disclosure must satisfy. The disclosure also relates to the production method.

This method is particularly well-suited when the covering material contains an organic material such as a resin.

The outgassing component may be eliminated either by treating a material before forming a covering layer of an electric wire or a cable, or by treating the covering layer after its formation.

Example methods for eliminating the outgassing component include thermal degassing. The thermal degassing is preferably performed on the covering layer of an electric wire or a cable.

The thermal degassing temperature is preferably not lower than 150°C or not lower than a temperature that is 100°C below a melting point of the covering material, more preferably not lower than 170°C, and is also preferably not higher than a temperature that is 20°C below a melting point of the covering material, and may be not higher than a temperature that is 50°C below a melting point of the covering material.

The thermal degassing may be performed at, but not limited to, atmospheric pressure, and the pressure of the thermal degassing is preferably $1.0 \times 10^{-2}$ Pa or lower, more preferably $5.0 \times 10^{-3}$ Pa or lower, still more preferably $1.0 \times 10^{-3}$ Pa or lower and may be $1.0 \times 10^{-5}$ Pa or higher, or $1.0 \times 10^{-4}$ Pa or higher.

The thermal degassing is preferably performed for a duration of five minutes or more, more preferably 30 minutes or more, still more preferably one hour or more, and is also preferably 10 hours or less, more preferably five hours or less, still more preferably three hours or less.

The thermal degassing may be performed with any equipment using any of the following methods, for example: placing a material to be processed in a SUS tray and treating it in a hot air electric furnace; placing a mesh at the bottom of a tray, with the mesh having an appropriate opening size to prevent the material to be processed from falling through; covering over a tray with a SUS mesh; and placing an material to be processed into a cylindrical SUS heatproof vessel and passing temperature-regulated hot air through the vessel from both the top and bottom, thereby maintaining the internal temperature. Here, reheating a previously heated material at a different temperature can enhance removal efficiency.

The disclosure relates to an electric wire or a cable containing: the covering material for an electric wire or a cable of the disclosure described above.

The electric wire or the cable of the disclosure preferably contains a conductor (core wire) and a covering layer formed on the outer periphery of the conductor and containing the covering material of the disclosure. The covering layer may be either single-layered or multilayered. The covering layer preferably contains the covering material of the disclosure at least in an outermost layer thereof.

In the disclosure, the electric wire may contain at least a conductor (core wire) and an insulating layer formed on the outer periphery of the conductor. The cable may be a sheathed single electric wire, or a plurality of electric wires in a bundle with its outer periphery sheathed.

The electric wire or the cable may also have an outer jacket. The outer jacket is formed on the outer periphery of the insulating layer of the electric wire or the outer periphery of the cable sheath. The outer jacket may or may not be in close contact with the underlying (inner) layer thereof. Examples of the outer jacket include foil, a vapor-deposited film, and a tubular member.

The electric wire or the cable of the disclosure preferably contains the covering material of the disclosure in the outermost layer thereof. Examples of the outermost layer include an insulating layer of the electric wire, a sheath of the cable, an outer jacket of the electric wire or the cable.

The covering material of the disclosure is preferably contained in an amount of 80% by mass or more, more

preferably 85% by mass or more, still more preferably 90% by mass or more, further preferably 95% by mass or more, particularly preferably 98% by mass or more relative to the outermost layer. The upper limit thereof may be, but not limited to, 100% by mass.

The conductor may be formed of any material having good conductivity. Examples of the material include copper, copper alloys, copper-clad aluminum, aluminum, silver, gold, zinc-plated iron, and carbon. The conductor may have any shape, such as either round or flat. The conductor may be either nickel-plated copper or silver-plated copper.

The electric wire or the cable of the disclosure is suitably produced by a production method including forming a covering layer on the outer periphery of the conductor using the covering material of the disclosure. The method for forming a covering layer is not limited and may be a known method. The various conditions for forming a covering layer may be known conditions. The covering layer containing the covering material of the disclosure may be formed either directly on the conductor or indirectly via a different layer such as different resin layer.

The electric wire or the cable of the disclosure is also suitably produced by a production method including eliminating an outgassing component having molecular weight of 200 or less to satisfy the specified condition(s).

This method is particularly well-suited when a covering layer forming material is an organic material such as a resin.

The outgassing component may be eliminated either by treating a material before forming a covering layer or by treating the covering layer after its formation.

The method for eliminating the outgassing component is the same as described in the methods for producing the covering material of the disclosure.

The covering material of the disclosure or the electric wire or cable of the disclosure is used for a vacuum device (vacuum chamber) in a semiconductor manufacturing apparatus. The covering material of the disclosure or the electric wire or cable of the disclosure may be used in a vacuum space inside the vacuum device. The covering material of the disclosure or the electric wire or cable of the disclosure may be partly present in a non-vacuum space, but at least the part present in a vacuum space must satisfy the specified condition(s).

Herein, the vacuum means an environment where the pressure is $1.0 \times 10^{-2}$ Pa or lower. The covering material of the disclosure or the electric wire or cable of the disclosure is preferably used in a space with a pressure of $5.0 \times 10^{-3}$ Pa or lower, more preferably $1.0 \times 10^{-3}$ Pa or lower, preferably $5.0 \times 10^{-4}$ Pa or lower, and the pressure may be $1.0 \times 10^{-5}$ Pa or higher or $1.0 \times 10^{-4}$ Pa or higher.

The covering material of the disclosure or the electric wire or cable of the disclosure is preferably used for a drive unit of the vacuum device. When the covering material particularly contains an organic material such as a resin, an electric wire or a cable to be obtained can exhibit excellent flexibility, and thus is suitably used for a drive unit.

The semiconductor manufacturing apparatus of the disclosure may be any semiconductor manufacturing apparatus that includes a vacuum device. The semiconductor manufacturing apparatus preferably includes an exposure apparatus, more preferably an extreme ultraviolet light exposure apparatus (EUV light exposure apparatus).

Inside a vacuum chamber of the EUV light exposure apparatus, an EUV light collecting mirror is commonly installed. It has been found that high emission of outgassing components from an electric wire or a cable inside a vacuum chamber of an EUV light exposure apparatus is likely to contaminate a light collecting mirror. The electric wire or the cable of the disclosure reduces emission of an outgassing component even when used in a vacuum, resulting in reduced contamination of a light collecting mirror in an EUV light exposure apparatus. This allows the suppression of decline in exposure energy, thus leading to increased throughput.

The semiconductor manufacturing apparatus of the disclosure also includes a semiconductor inspecting device. The semiconductor inspecting device may be any semiconductor inspecting device that includes a vacuum device, with an inspecting device equipped with an EUV light source being preferred.

A vacuum device for a semiconductor manufacturing apparatus including the electric wire or the cable of the disclosure, and a semiconductor manufacturing apparatus including the vacuum device for a semiconductor manufacturing apparatus are preferred embodiments of the disclosure.

It should be appreciated that a variety of modifications and changes in the structure and other details may be made to the aforementioned embodiments without departing from the spirit and scope of the claims.

## EXAMPLES

The disclosure is described in more detail below with reference to examples, but is not limited to these examples.

The physical properties were determined by the following methods.

<Number of terminal functional group>

The number of terminal functional groups was determined as follows. A 200-μm-thick film was subjected to the infrared spectrum analysis. In the resulting infrared absorption spectrum, the absorbance of the peak present at 2900 to

3100 $cm^{-1}$ assigned to the $CH_2$ groups in the main chain was standardized to 1.0. The absorbance A of the peak assigned to the terminal functional groups in this spectrum was then determined and the number of the terminal functional groups was calculated by the following formula. Coefficient K is as shown in Table 1.

Number of terminal functional groups per $10^6$ main chain carbon atoms = K $\times$ A

<Measurement of gas emission rate in high vacuum (evaluation of condition A) and QMS measurement>

(Throughput method test /Gas emission rate up to 48 hours)

A sample was put in a test chamber, followed by switching to orifice exhaust when the pressure reached a specific value. After the pressure (P1) of a sample chamber fell below 1.0 $\times$ $10^{-2}$ Pa, the measurement by Q-Mass (QMS) was initiated. The test continued for 48 hours from the initiation of the QMS measurement under the conditions described above. During the test, the temperature of the sample chamber was held at 20°C to 30°C and a pressure of 1.0 $\times$ $10^{-2}$ to 1.0 $\times$ $10^{-4}$ Pa. The pressure was measured for the period from the initiation to the end of vacuum exhaust to calculate the gas emission rate Q by the following formula:

$$Q = C(P1-P2)$$

wherein C is an orifice conductance ($m^3/s$), P1 is an orifice upstream (sample chamber side) pressure (Pa), and P2 is an orifice downstream (exhaust chamber side) pressure (Pa).

The calculated gas emission rate was standardized with a surface area of the sample to determine the gas emission rate per unit surface area of the sample.

The outgassing component emitted was analyzed using the QMS measurement.

<Measurement of partial pressure of outgassing component having molecular weight of 200 or less upon exposure to EUV light (evaluation of condition B)>

After the degree of vacuum in an exposure chamber fell below 1.0 $\times$ $10^{-4}$ Pa, EUV light with a wavelength of 13.5 nm and beam size 2.6 mm $\times$ 4.1 mm was directed to the surface of a sample placed in an exposure chamber. During the EUV irradiation, the chamber was held at a temperature of 20°C to 30°C and a pressure of 1.0 $\times$ $10^{-4}$ Pa or lower. The result of QMS measurement without EUV irradiation served as baseline value. The value obtained by subtracting the baseline value from the result of the QMS measurement during the EUV irradiation was defined as an actual amount of outgassing amount during the EUV irradiation. Furthermore, the partial pressure of outgassing components having a molecular weight of 200 or less upon exposure to EUV light was determined by subtracting partial pressures of atmosphere components such as water (molecular weight: 18), nitrogen (molecular weight: 28), oxygen (molecular weight: 32), argon (molecular weight: 40), and carbon dioxide (molecular weight: 44) from the sum of partial pressures of outgassing components having molecular weight of 200 or less.

<Measurement of partial pressure of CF component upon exposure to EUV light (evaluation of condition C)>

After the degree of vacuum in an exposure chamber falls below 1.0 $\times$ $10^{-4}$ Pa, EUV light with a wavelength of 13.5 nm and beam size 2.6 mm $\times$ 4.1 mm is directed to the surface of a sample placed in an exposure chamber. During the EUV irradiation, the chamber is held at a temperature of 20°C to 30°C and a pressure of 1.0 $\times$ $10^{-4}$ Pa or lower. The result of QMS measurement without EUV irradiation serves as baseline value. The value obtained by subtracting the baseline value from the result of the QMS measurement during the EUV irradiation is defined as an actual amount of outgassing amount during the EUV irradiation. Furthermore, the sum of partial pressures of components such as ($C_2F_4$) having a molecular weight of 100, ($C_2F_5$) having a molecular weight of 119, and ($C_3F_7$) having a molecular weight of 169 is determined as the partial pressure of CF components upon exposure to EUV light.

The following materials and electric wires were used in examples and comparative examples.

PTFE (1): TFE homopolymer, number of terminal functional groups: 6
PTFE (2): Mixture of PTFE (1) and 0.1% by mass of pigment (615.00 Disp Pigment PTFE Black, available from Colorant Chromatics)
PTFE (3): PTFE (1) treated by thermal degassing at 200°C and atmospheric pressure for two hours
PFA (1): TFE/PPVE copolymer, number of terminal functional groups: 50
PFA (2): TFE/PPVE copolymer, number of terminal functional groups: 6
FEP: TFE/HFP copolymer, number of terminal functional groups: 7

ETFE: Et/TFE copolymer, number of terminal functional groups: 10
Polyimide (PI): 31311AC-KAP1, available from Vytek Ltd.
Polyetheretherketone (PEEK): thermocouple wire insulated with PEEK resin 0.32 × 1P T-2-PEEK-J1, available from Ninomiya Electric Wire Co., Ltd.
Ceramic: Insulated ceramic braided thermocouple wire, available from Ninomiya Electric Wire Co., Ltd.
Polyethylene (PE): HB-KX 0.2SQ 1000, available from Misumi Group Inc.

Examples 1 to 7

A covering layer was formed on a conductor using materials shown in Table 2 to obtain an electric wire. The obtained electric wire was subjected to the measurement of gas emission rate in a high vacuum, the measurement of partial pressure of outgassing components having a molecular weight of 200 or less, and the measurement of partial pressure of CF components upon exposure to EUV light.

The results are shown in Table 2.

Examples 8 to 10 and Comparative Example 1

The electric wire product with a covering layer that contained materials shown in Table 2 was subjected to the measurement of gas emission rate in a high vacuum and the measurement of partial pressure of outgassing components having a molecular weight of 200 or less.

The results are shown in Table 2.

[Table 2]

| | Example 1 | Example 2 | Example 3 | Example 4 | Example 5 | Example 6 | Example 7 | Example 8 | Example 9 | Example 10 | Comparative Example 1 |
|---|---|---|---|---|---|---|---|---|---|---|---|
| Material of insulator | PTFE(1) | PTFE(2) | PTFE(3) | PFA(1) | PFA(2) | FEP | ETFE | PI | PEEK | Ceramic | PE |
| Outer diameter of electric wire (mm) | 2.3 | 2.3 | 2.3 | 0.5 | 0.5 | 0.5 | 0.5 | 0.55 | 0.9×1.5 | 1.6×2.4 | 1 |
| Number of terminal functional group (per $10^6$ main chain carbon atoms) | 6 | 6 | 6 | 50 | 6 | 7 | 10 | - | - | - | - |
| Thermal degassing | - | - | 200°C, 1 hour | - | - | - | - | - | - | - | - |
| Pigment | - | Included | - | - | - | - | - | - | - | - | - |
| Gas emission rate in high vacuum $\times 10^{-9}$ ($Pa \cdot m^3/s/cm^2$) | 0.162 | 0.152 | 0.101 | 0.487 | 0.126 | 0.214 | 0.218 | 7.56 | 1.07 | 0.248 | 3.46 |
| Partial pressure of outgassing component having molecular weight of 200 or less upon exposure to EUV light $\times 10^{-7}$ (Pa) | 1.51 | 4.65 | 1.21 | 5.42 | 4.65 | 3.36 | 4.60 | 5.54 | 11.3 | 2.12 | 15.1 |
| Partial pressure of CF component upon exposure to EUV light $\times 10^{-10}$ (Pa) | 4.61 | 4.74 | 4.41 | 35.3 | 13.1 | 14.3 | 4.61 | - | - | - | - |
| Condition A | ○ | ○ | ○ | ○ | ○ | ○ | ○ | × | ○ | ○ | × |
| Condition B | ○ | ○ | ○ | ○ | ○ | ○ | ○ | ○ | × | ○ | × |
| Condition C | ○ | ○ | ○ | × | ○ | ○ | ○ | - | - | - | - |

The outgassing component emitted during the measurement of gas emission rate in a high vacuum was analyzed using the QMS measurement.

In Examples 1 to 6, the outgassing components detected were only atmosphere components such as water (molecular weight: 18), nitrogen (molecular weight: 28), oxygen (molecular weight: 32), argon (molecular weight: 40), and carbon dioxide (molecular weight: 44). In Comparative Example 1, the peak of $CH_2$ (molecular weight: 14) unit was detected and outgassing components were hydrocarbon-based components derived from the covering material.

## Claims

1. A covering material for an electric wire or a cable, the covering material being for use in a vacuum device in a semiconductor manufacturing apparatus,
   the covering material satisfying the following condition A:
   (condition A)
   a sample has a gas emission rate per unit surface area of $2.0 \times 10^{-9}$ Pa·m$^3$/s/cm$^2$ or lower after being left to stand at 20°C to 30°C and $1.0 \times 10^{-2}$ to $1.0 \times 10^{-4}$ Pa for 48 hours.

2. A covering material for an electric wire or a cable, the covering material being for use in a vacuum device in a semiconductor manufacturing apparatus,
   the covering material satisfying the following condition B:
   (condition B)
   an outgassing component having a molecular weight of 200 or less has a partial pressure of $1.0 \times 10^{-6}$ Pa or lower upon exposure to EUV light at 20°C to 30°C and $1.0 \times 10^{-4}$ Pa or lower.

3. A covering material for an electric wire or a cable, the covering material being for use in a vacuum device in a semiconductor manufacturing apparatus,
   the covering material satisfying the following conditions A and B:

   (condition A)
   a sample has a gas emission rate per unit surface area of $2.0 \times 10^{-9}$ Pa·m$^3$/s/cm$^2$ or lower after being left to stand at 20°C to 30°C and $1.0 \times 10^{-2}$ to $1.0 \times 10^{-4}$ Pa for 48 hours;
   (condition B)
   an outgassing component having a molecular weight of 200 or less has a partial pressure of $1.0 \times 10^{-6}$ Pa or lower upon exposure to EUV light at 20°C to 30°C and $1.0 \times 10^{-4}$ Pa or lower.

4. A covering material for an electric wire or a cable, the covering material being for use in a vacuum device in a semiconductor manufacturing apparatus,
   the covering material satisfying the following conditions A, B, and C:

   (condition A)
   a sample has a gas emission rate per unit surface area of $2.0 \times 10^{-9}$ Pa·m$^3$/s/cm$^2$ or lower after being left to stand at 20°C to 30°C and $1.0 \times 10^{-2}$ to $1.0 \times 10^{-4}$ Pa for 48 hours;
   (condition B)
   an outgassing component having a molecular weight of 200 or less has a partial pressure of $1.0 \times 10^{-6}$ Pa or lower upon exposure to EUV light at 20°C to 30°C and $1.0 \times 10^{-4}$ Pa or lower;
   (condition C)
   a CF component has a partial pressure of $2.0 \times 10^{-9}$ Pa or lower upon exposure to EUV light at 20°C to 30°C and $1.0 \times 10^{-4}$ Pa or lower.

5. The covering material for an electric wire or a cable according to any one of claims 1 to 4,
   wherein the covering material contains a resin.

6. The covering material for an electric wire or a cable according to claim 5,
   wherein the resin includes at least one selected from the group consisting of a fluororesin, a polyimide resin, and a polyetheretherketone resin.

7. The covering material for an electric wire or a cable according to claim 5,
   wherein the resin includes a fluororesin.

**8.** The covering material for an electric wire or a cable according to claim 7, wherein the fluororesin includes an ethylene/tetrafluoroethylene copolymer.

**9.** The covering material for an electric wire or a cable according to claim 7, wherein the fluororesin includes a perfluororesin.

**10.** The covering material for an electric wire or a cable according to claim 9, wherein the perfluororesin includes at least one selected from the group consisting of polytetrafluoroethylene, a tetrafluoroethylene/perfluoro(alkyl vinyl ether) copolymer, and a tetrafluoroethylene/hexafluoropropylene copolymer.

**11.** The covering material for an electric wire or a cable according to claim 9 or 10, wherein the perfluororesin has 40 or less terminal functional groups, per $10^6$ main chain carbon atoms.

**12.** The covering material for an electric wire or a cable according to any one of claims 7 to 11, wherein the fluororesin has 10 or less terminal functional groups, per $10^6$ main chain carbon atoms.

**13.** An electric wire or a cable comprising:
the covering material for an electric wire or a cable according to any one of claims 1 to 12.

**14.** The electric wire or the cable according to claim 13, wherein the electric wire or the cable contains the covering material for an electric wire or a cable in an outermost layer thereof.

**15.** A vacuum device for a semiconductor manufacturing apparatus, comprising:
the electric wire or the cable according to claim 13 or 14.

**16.** A semiconductor manufacturing apparatus comprising:
the vacuum device for a semiconductor manufacturing apparatus according to claim 15.

**17.** The semiconductor manufacturing apparatus according to claim 16, wherein the semiconductor manufacturing apparatus includes an EUV light exposure apparatus.

**18.** A method for producing the covering material for an electric wire or a cable according to any one of claims 1 to 12, the method comprising:
eliminating an outgassing component having molecular weight of 200 or less to satisfy the condition.

**19.** The production method according to claim 18, wherein the outgassing component is eliminated by thermal degassing.

**20.** The production method according to claim 19,

wherein the thermal degassing is performed at a temperature ranging from 150°C to a temperature that is 20°C or more below a melting point of the covering material for an electric wire or a cable,
wherein the thermal degassing is performed for a duration of five minutes to three hours.

## INTERNATIONAL SEARCH REPORT

International application No.
**PCT/JP2025/020245**

### A. CLASSIFICATION OF SUBJECT MATTER

***H01B 3/30***(2006.01)i; ***G03F 7/20***(2006.01)i; ***H01L 21/02***(2006.01)i
FI: H01B3/30 Z; G03F7/20 503; H01L21/02 Z

According to International Patent Classification (IPC) or to both national classification and IPC

### B. FIELDS SEARCHED

Minimum documentation searched (classification system followed by classification symbols)

H01B3/30; G03F7/20; H01L21/02

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 5-314821 A (SUMITOMO ELECTRIC INDUSTRIES, LTD.) 26 November 1993 (1993-11-26)<br>paragraphs [0001]-[0037], fig. 1 | 1, 13-20 |
| Y | JP 2019-172962 A (DAIKIN INDUSTRIES, LTD.) 10 October 2019 (2019-10-10)<br>paragraphs [0072]-[0077], [0090]-[0093], [0099]-[0100], table 3 | 1-7, 9-17 |
| A | paragraphs [0072]-[0077], [0090]-[0093], [0099]-[0100], table 3 | 8 |
| Y | WO 2020/054778 A1 (JUNKOSHA INC.) 19 March 2020 (2020-03-19)<br>paragraphs [0002]-[0003], [0010]-[0019] | 1-7, 9-17 |
| Y | JP 2004-158354 A (SUMITOMO ELECTRIC INDUSTRIES, LTD.) 03 June 2004 (2004-06-03)<br>paragraphs [0001]-[0003], [0020]-[0025] | 1-7, 9-17 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **30 July 2025** | **12 August 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2025/020245**

**C. DOCUMENTS CONSIDERED TO BE RELEVANT**

| Category* | Citation of document, with indication, where appropriate, of the relevant passages | Relevant to claim No. |
|---|---|---|
| A | 赤石 憲也, 技術ノート（超高真空技術）, 応用物理, 第４５巻 第１号, 中門 留一 社団法人応用物理学会, 09 January 1975 (accession date), p. 55, non-official translation (AKAISHI, Kenya, Technical Notes (Ultra-High Vacuum Technology), Oyo Buturi, vol. 45, no. 1, NAKAMON, Ryuichi, The Japan Society of Applied Physics) entire text | 1-20 |

Form PCT/ISA/210 (second sheet) (July 2022)

**INTERNATIONAL SEARCH REPORT**
**Information on patent family members**

International application No.
**PCT/JP2025/020245**

| Patent document cited in search report | Publication date (day/month/year) | Patent family member(s) | Publication date (day/month/year) |
|---|---|---|---|
| JP 5-314821 A | 26 November 1993 | (Family: none) | |
| JP 2019-172962 A | 10 October 2019 | US 2021/0024769 A1 paragraphs [0078]-[0083], [0106]-[0115], [0125]-[0130], table 3 | |
| WO 2020/054778 A1 | 19 March 2020 | US 2022/0044846 A1 paragraphs [0002]-[0003], [0022]-[0032] | |
| JP 2004-158354 A | 03 June 2004 | (Family: none) | |

Form PCT/ISA/210 (patent family annex) (July 2022)

## REFERENCES CITED IN THE DESCRIPTION

*This list of references cited by the applicant is for the reader’s convenience only. It does not form part of the European patent document. Even though great care has been taken in compiling the references, errors or omissions cannot be excluded and the EPO disclaims all liability in this regard.*

### Patent documents cited in the description


- WO 2010081721 A